# DEMANDE DE BREVET EUROPEEN

(11) **EP 1 447 809 A1**
(43) Date de publication de la demande: **18.08.2004**
(21) Numéro de dépôt: 03290365.0
(22) Date de dépôt: 14.02.2003
(51) Int. Cl.: G11C 5/14

(54) **Carte à multi-puce**

(71) Demandeur: SCHLUMBERGER Systèmes, 92120 Montrouge (FR)
(72) Inventeur: Rhelimi, Alain, c/o Schlumberger Systèmes, 92120 Montrouge (FR)
(74) Mandataire: den Braber, Gerard Paul

(57) **Abrégé**

Un objet portatif (1) de type carte à puce comprend plusieurs circuits intégrés (3, 10). L'objet portatif (1) comprend un circuit d'alimentation (2, 7, 9) agencé pour fournir une tension d'alimentation (3 à 5 volts) à un desdits circuits intégrés (3) et pour fournir une autre tension d'alimentation (1.2 à 1.8 volts) à un autre desdits circuits intégrés (10).

## Description

### DOMAINE TECHNIQUE

L'invention concerne des objets intelligents portatifs communément appelés cartes à microprocesseur ou « cartes à puce ».

### ETAT DE LA TECHNIQUE ANTERIEURE

Les normes ISO 7816 (format ID-0) et GSM 11.11 (format ID-000) décrivent des cartes à puce. Les cartes à puce comprennent généralement un circuit intégré (puce) appelé « microcontrôleur ». Le microcontrôleur comprend typiquement les élément suivants :
- une unité de calcul (en anglais : processing unit)
- une mémoire volatile (RAM)
- une ou plusieurs mémoires non volatile (ROM et EEPROM/Flash).
- une interface de communication vers un appareil extérieur tel que définit dans la norme IS07816-3 et IS07816-12.

La publication brevet WO2002084587 décrit une carte à puce comprenant plusieurs circuits intégrés qui sont reliés par un bus de communication. Ces circuits intégrés reçoivent une tension d'alimentation d'un bus unique d'alimentation. En conséquence, la tension d'alimentation est unique.

### EXPOSE DE L'INVENTION

Un but de l'invention est de permettre une plus grande fonctionnalité pour un certain prix donné.

Selon l'invention, un objet portatif de type carte à puce comprenant plusieurs circuits intégrés, est caractérisé en ce que l'objet portatif comprend un circuit d'alimentation agencé pour fournir une tension d'alimentation à un desdits circuits intégrés et pour fournir une autre tension d'alimentation à un autre desdits circuits intégrés.

L'invention prend les aspects suivants en considération. La tension d'alimentation préférée d'un certain circuit intégré dépend généralement de la technologie utilisée pour fabriquer ce circuit intégré en termes d'épaisseur de gravure. Par conséquent, l'utilisation d'une tension d'alimentation unique dans une carte à puce comprenant plusieurs circuits intégrés, implique que ces circuits intégrés sont fabriqués selon la même technologie, par exemple selon une technologie de 0.35 µm, 0.35 µm étant l'épaisseur de gravure. Par exemple, considérons une carte à puce comprenant deux circuits intégrés : un microcontrôleur et une mémoire « Flash ». Supposons que le microcontrôleur est fabriqué selon la technologie 0.35 µm. Dans ce cas, la mémoire « Flash » est de préférence également fabriquée selon la technologie 0.35 µm. L'inverse s'applique également. Donc, l'art antérieur oblige le concepteur de cartes à puce qui désire répartir des fonctionnalités sur plusieurs circuits intégrés dans une seule carte à puce, de choisir des circuits intégrés fabriqués selon des technologies compatibles ou identiques.

Les circuits intégrés de type « mémoires » peuvent généralement être réalisées dans une gravure relativement fine. Une gravure relativement fine implique généralement une tension d'alimentation relativement basse. En contrepartie, les microcontrôleurs destinés pour des cartes à puces nécessitent une gravure relativement épaisse. Une gravure relativement épaisse implique généralement une tension d'alimentation relativement élevée. Par exemple, en 2003 la gravure des mémoires de technologie « Flash » autorisant des capacités supérieures à 64 MBits par composant, est d'environ 0,13µm et opèrent avec une tension d'alimentation de 1,8 Volt. En contrepartie, les microcontrôleurs pour des cartes à puce dispose d'une technologie de 0,35 µm et nécessitent une alimentation de 3 volts.

Selon l'invention, un objet portatif comme, par exemple, une carte à puce, comprend un circuit d'alimentation agencé pour fournir une tension d'alimentation à un circuit intégré et pour fournir une autre tension d'alimentation à un autre circuit intégré.

Donc, l'invention permet au prix d'un tel circuit d'alimentation l'utilisation de circuits intégrés fabriqués selon différentes technologies dans une seule carte à puce. Le surcoût d'un tel circuit d'alimentation sera généralement moins important par rapport au gain possible en utilisant, pour un ou plusieurs types de circuit intégré, le circuit intégré selon la technologie la plus récente. Ceci permet, par exemple, à doter une carte a puce d'une mémoire plus grande pour un certain prix donné. Par conséquent, l'invention permet une plus grande fonctionnalité pour un certain prix donné.

Ces aspects de l'invention ainsi que d'autres aspects seront décrits plus en détail dans la description qui suit en référence aux Figures.

### BREVE DESCRIPTION DES FIGURES

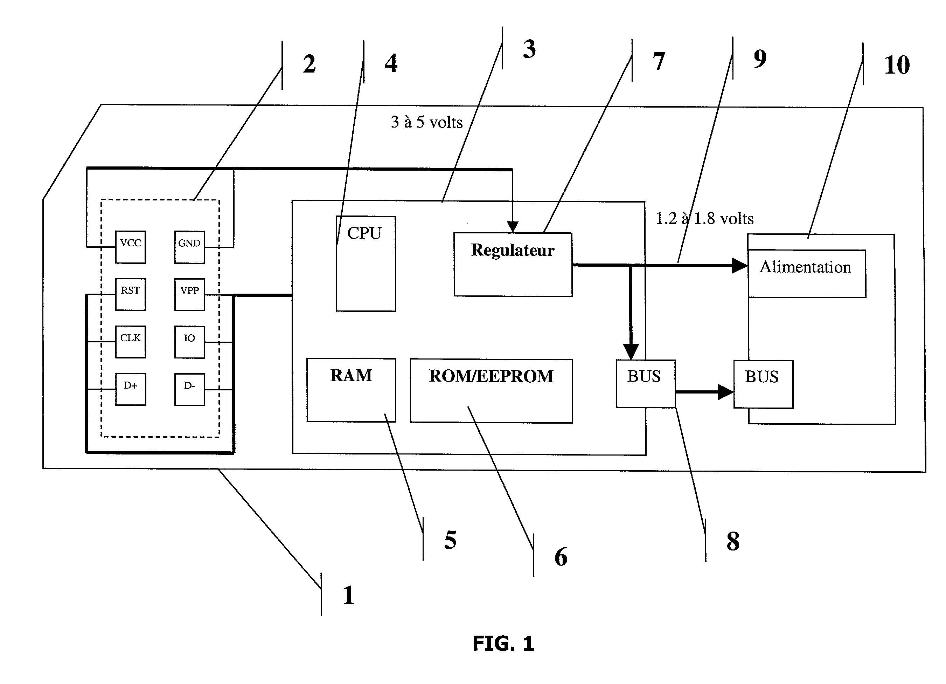

La Figure 1 est un diagramme illustrant une carte à puce selon l'invention.

### DESCRIPTION DETAILLEE

La Figure 1 illustre une carte à puce 1 au format ID-000 du standard GSM 11.11. La carte à puce 1 comprend une plage de contacts 2 connectés à un microcontrôleur 3. Le microcontrôleur 3 inclut une unité de calcul 4, une mémoire volatile 5 de type « RAM » et une mémoire non-volatile 6 de type « EEPROM », « ROM » ou « FLASH ». Le microcontrôleur 3 intègre ainsi l'ensemble des fonctionnalités de base d'une carte à puce. Le microcontrôleur 3 dispose en outre d'un régulateur de tension 7. Ce régulateur de tension 7 est programmable. Le régulateur de tension 7 permet l'alimentation d'un bus de communication 8 et l'alimentation électrique via un bus d'alimentation 9 d'une mémoire supplémentaire 10 externe au microcontrôleur mais inclus dans la carte à puce 1. Le bus de communication 8 comprend une interface incorporée dans le microcontrôleur 1 et une autre interface incorporée dans la mémoire supplémentaire 10.

Le microcontrôleur 3 reçoit une tension d'alimentation provenant de l'extérieur de la carte à puce 1 via un contact VCC de la plage de contacts 2. Cette tension d'alimentation provient, par exemple, d'un téléphone mobile dans lequel la carte à puce est insérée. La tension d'alimentation applique à la plage VCC et fournie au microcontrôleur se situe typiquement dans une plage de 3 à 5 Volt. Elle sera appelée tension d'alimentation primaire par la suite. Le régulateur de tension 7 reçoit la tension d'alimentation primaire et génère à partir de celle-ci une tension d'alimentation secondaire. La tension d'alimentation secondaire se situe de préférence dans une plage de 1.2 à 1.8 Volt. La mémoire supplémentaire 10 reçoit la tension d'alimentation secondaire via le bus d'alimentation 9. Ceci permet d'alimenter la mémoire supplémentaire 10 avec une tension compatible avec la technologie selon laquelle cette mémoire a été fabriquée. Le bus de communication 8 qui relie la mémoire supplémentaire au microcontrôleur 3 reçoit également la tension d'alimentation secondaire. Plus précisément, la tension d'alimentation secondaire est appliquée à l'interface incorporée dans le microcontrôleur 3. Ainsi, les niveaux des signaux transmis via le bus de communication 8 sont compatibles avec la technologie de la mémoire supplémentaire 10.

Le régulateur de tension 7 peut couper l'alimentation de la mémoire supplémentaire 10 quand celle-ci n'est pas utilisée, par exemple en période de veille (en anglais : sleep mode). Ceci permet une réduction de la puissance électrique consommée par la carte à puce 1. Le régulateur de tension 7 réglable ou programmable : la tension d'alimentation secondaire dépend d'une valeur de commande présente dans le microcontrôleur 3. Par exemple, cette valeur de commande peut être programmée dans la mémoire volatile 5 ou la mémoire non-volatile 6 lors de la personnalisation de la carte à puce 1. Ainsi, il est possible de combiner un microcontrôleur d'un certain type avec des mémoires supplémentaires fabriquées selon différentes technologies. La tension d'alimentation secondaire sera réglée en fonction de la technologie de la mémoire supplémentaire.

Il convient de noter que la mémoire supplémentaire 10 ne possèdent pas de connections externes au corps de carte 1. La connexion avec l'extérieur se fait via le microcontrôleur 3. Ainsi, la mémoire supplémentaire 10 ne nécessite pas de précautions particulières pour se prémunir des décharges électrostatiques.

La description ci-dessus illustre les caractéristiques suivantes. Un objet portatif (la carte à puce 1) de type carte à puce comprend plusieurs circuits intégrés (le microcontrôleur 3, la mémoire supplémentaire 10). L'objet portatif (la carte à puce 1) comprend un circuit d'alimentation (la plage de contacts 2, le régulateur de tension 7, le bus d'alimentation 9) agencé pour fournir une tension d'alimentation (3 à 5 volts) à un desdits circuits intégrés (le microcontrôleur 3) et pour fournir une autre tension d'alimentation (1.2 à 1.8 volts) à un autre desdits circuits intégrés (la mémoire supplémentaire 10).

La description ci-dessus en référence à la Figure 1 illustre l'invention plutôt qu'elle ne la limite. Il est évident qu'il existe de nombreuses alternatives qui rentrent dans la portée des revendications ci-jointes. A cet égard, quelques remarques sont faites en conclusion.

Une carte à puce selon l'invention peut, en principe, comprendre n'importe quel type de circuit intégré. La carte à puce 1 illustré à la Figure 1 n'est qu'un exemple. Par exemple, une carte à puce selon l'invention peut comprendre un circuit intégré constituant un co-processeur. Ce co-processeur peut être agencé, par exemple, pour effectuer des calculs cryptographiques. Il est bien évident qu'une carte à puce selon l'invention peut comprendre trois ou plusieurs circuits intégrés. Par exemple, une carte à puce selon l'invention peut comprendre un microcontrôleur, une ou plusieurs mémoires et une ou plusieurs co-processeurs.

Il existe de nombreuses manières pour fournir une tension d'alimentation à un circuit intégré dans une carte à puce et une autre tension d'alimentation à un autre circuit intégré dans la même carte à puce. Par exemple, une carte à puce peut comprendre un circuit d'alimentation qui reçoit une tension d'alimentation de l'extérieur via une plage VCC et qui, en réponse, génère plusieurs tensions d'alimentation. Une de ces tensions alimente, par exemple, un microcontrôleur et une autre tension alimente, par exemple, une mémoire. Dans une telle implémentation, la tension d'alimentation de l'extérieur n'alimente donc pas directement le microcontrôleur contrairement à l'implémentation illustrée à la Figure 1.

Une carte à puce selon l'invention peut comprendre un circuit intégré qui nécessite plusieurs différentes tensions d'alimentation. Par exemple, un circuit intégré peut comprendre un circuit électronique de coeur (Core) et un circuit électronique d'interface (IO buffer), les deux circuits électroniques nécessitant des tensions d'alimentation différentes. Dans une telle implémentation, la carte peut comprendre un régulateur de tension qui fournit les différentes tension d'alimentations nécessaires via un bus d'alimentation comparable au bus d'alimentation 9 de la carte à puce 1 illustrée à la Figure 1.

En ce qui concerne les revendications ci-jointes, il convient de noter que le mot "comprenant" n'exclut pas la présence d'autres éléments ou étapes listés dans une revendication. Le mot "un" ou "une" précédant un élément ou une étape n'exclut pas la présence d'une pluralité de ces éléments ou ces étapes.

## Revendications

1. Objet portatif de type carte à puce comprenant plusieurs circuits intégrés, **caractérisé en ce que** l'objet portatif comprend un circuit d'alimentation agencé pour fournir une tension d'alimentation à un desdits circuits intégrés et pour fournir une autre tension d'alimentation à un autre desdits circuits intégrés.

2. Objet portatif selon la revendication 1, **caractérisé en ce que** le circuit d'alimentation comprend un modificateur de tension agencé pour recevoir une tension d'alimentation primaire destinée à un desdits circuit intégré et pour générer à partir de la tension d'alimentation primaire une tension d'alimentation secondaire destinée à un autre desdits circuits intégrés.

3. Objet portatif selon la revendication 2, **caractérisé en ce que** le modificateur de tension est réglable afin de régler la tension d'alimentation secondaire.

4. Objet portatif selon la revendication 2, **caractérisé en ce que** le modificateur de tension est agencé pour couper la tension d'alimentation secondaire.

5. Objet portatif selon la revendication 2, **caractérisé en ce que** le modificateur de tension est incorporé dans un desdits circuits intégrés.

6. Objet portatif selon la revendication 5, **caractérisé en ce que** le circuit intégré dans lequel est incorporé le modificateur de tension, constitue un microcontrôleur.

7. Objet portatif selon la revendication 3 et 6, **caractérisé en ce que** le microcontrôleur est agencé pour régler la tension d'alimentation secondaire.

8. Objet portatif selon la revendication 4 et 6, **caractérisé en ce que** le microcontrôleur est agencé pour couper la tension d'alimentation secondaire.

9. Objet portatif selon la revendication 6, **caractérisé en ce qu'**un autre desdits circuits intégrés constitue une mémoire relié au microcontrôleur par une voie d'alimentation agencé pour appliquer la tension d'alimentation secondaire à la mémoire.

10. Objet portatif selon la revendication 9, **caractérisé en ce que** le microcontrôleur comprend une interface pour communiquer avec la mémoire et une voie d'alimentation interne pour fournir la tension d'alimentation secondaire à l'interface.
